# EUROPEAN PATENT APPLICATION

(11) **EP 2 696 547 A2**
(43) Date of publication of application: **12.02.2014**
(21) Application number: 13164283.7
(22) Date of filing: 18.04.2013
(51) Int. Cl.: H04L 25/03

(54) **Adaptive equalization**

(30) Priority: 08.08.2012 KR 20120086814
(71) Applicant: Samsung Electronics Co., Ltd, Gyeonggi-do 443-742 (KR)
(72) Inventor: Lee, Cheol-ho, Gyeonggi-do (KR)
(74) Representative: Hewett, Jonathan Michael Richard

(57) **Abstract**

A signal processor includes a receiver to receive data to be transmitted to an external device, a signal generator to process de-emphasis of the received data using a preset de-emphasis value and to output the resultant data to the external device, an information acquisition unit to receive equalizer information from the external device, and a controller to control the de-emphasis value of the signal generator based on the received equalizer information.

## Description

The present invention relates to a signal processor, an electronic apparatus including the signal processor, a signal processing method and a computer-readable recording medium, and more particularly, to a signal processor capable of adaptably controlling de-emphasis gain value of a de-emphasis according to a system environment, an electronic apparatus including the signal processor, a signal processing method and a computer-readable recording medium.

Electronic apparatuses include various interfaces, and recently, the high speed serial bus such as the Serial ATA (SATA) communicating with the hard disk or the optical driver has been applied.

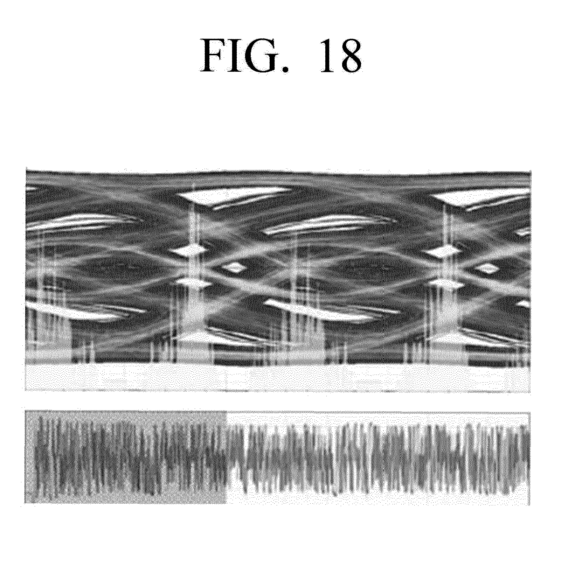

The serial bus refers to an interface which transmits data based on one bit per communication cycle. Because recent serial buses perform at high speed, the inter-symbol interference (ISI), the skin effect (or wave effect), and electric loss may happen. The 'skin effect' indicates decline of the conductivity or increase of the resistivity observed during streaming logging in a material with high conductivity, and the 'electric loss' indicates loss occurring when alternating current (AC) electrical field is applied to a dielectric substance. The 'ISI' indicates interference wherein the symbol waveform of one time slot affects the symbol waveform of another time slot due to the bandwidth limitation by the transmitting route or the amplifier or to the nonlinear characteristics of the phase on the transmitting route. A wave distorted by ISI is illustrated in FIG. 18.

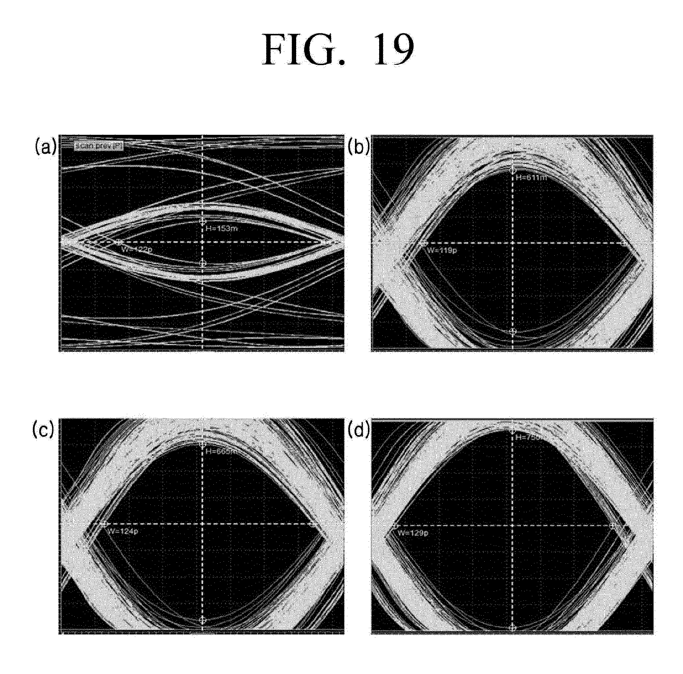

The ISI can be compensated by de-emphasis technology or equalizer technology. Specifically, the transmitting end of the serial bus transmits the signals by considering the ISI using the de-emphasis technology, and the receiving end of the serial bus improves the received waveform using the equalizer technology. An example of the signal waveform to which de-emphasis technology and equalizer technology are applied is illustrated in FIG. 19. More specifically, FIG. 19A illustrates a signal waveform without de-emphasis and equalizer technologies, FIG. 19B illustrates a signal waveform with de-emphasis technology only, FIG. 19C illustrates a signal waveform with equalizer technology only, and FIG. 19D illustrates a signal waveform with both de-emphasis technology and the equalizer technology.

Meanwhile, transmitting channels become more complicated, and signals run at higher speeds. It is often difficult to compensate the signals to the desirable level with only one technology. Thus, when transmitting signals on a high speed of the GHz bandwidth, the signal quality is ensured by applying both the de-emphasis technology and the equalizer technology.

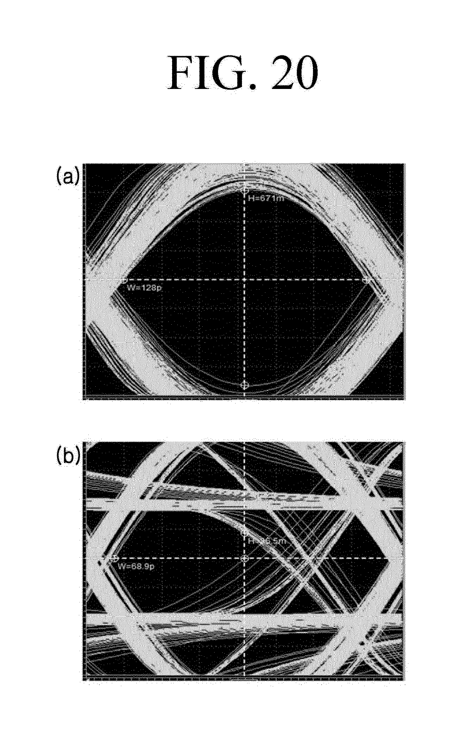

However, the conventional serial interface utilizes a fixed de-emphasis value and a fixed equalizer value when applying the de-emphasis technology and the equalizer technology. Thus, the signals can be rather distorted when a new device is connected. This will be further described below by referring to FIG. 20.

FIG. 20 illustrates the simulation results of the applied equalizer technology and the unapplied equalizer technology in the same system applied with the same de-emphasis.

Conventionally, de-emphasis and equalization are implemented using fixed de-emphasis and equalizer values which are optimized via various logging methods such as simulation. Accordingly, the transmitting signal does not have the distortion as illustrated in FIG. 20A.

However, if a user selects and installs a new device, since the system does not find the setting equalizer value for the newly installed device, it sets and utilizes a preset de-emphasis value without considering the equalization features of the newly installed device.

If the de-emphasis value is set as a high gain value, and if the equalizer of the newly installed device is also set as high gain value, the system may perform a disorientating operation by causing the strong distortion in the waveform as illustrated in FIG. 20B. Thus, depending on e-emphasis characteristics, the signal characteristic can deteriorate more severely than without equalization.

The present invention provides a signal processor to adaptably adjust a de-emphasis gain value according to a system environment, an electronic apparatus including the signal processor, a signal processing method, and a computer readable recording medium.

Additional features and utilities of the present invention will be set forth in part in the description which follows and, in part, will be obvious from the description, or may be learned by practice of the invention.

The foregoing and/or other features and utilities of the present invention may be achieved by providing a signal processor including a receiver to receive data to be transmitted to an external device, a signal generator to process de-emphasis of the received data using a preset de-emphasis value and to output the resultant data to the external device, an information acquisition unit to receive equalizer information from the external device, and a controller to control the de-emphasis value of the signal generator based on the received equalizer information.

The equalizer information may include a gain value of an equalizer provided in the external device.

The signal processor may additionally include a storage which stores a plurality of equalizer gain values and a plurality of de-emphasis gain values corresponding to the plurality of equalizer gain values to a look-up table. The controller may control the de-emphasis gain value of the signal generator based on the look-up table stored in the storage and the received equalizer information.

The look-up table may classify and store the de-emphasis gain values based on whether the de-emphasis gain values meet a first condition or a second condition, and the controller may control the de-emphasis gain value of the signal generator according to the de-emphasis gain values meeting the first condition and the de-emphasis gain values meeting the second condition, depending on an operation status of the signal processor.

The first condition may give priority to a size of the signal waveform and the second condition may give priority to a width of signal timing.

The controller may control the signal generator to communicate on a first communication speed before adjusting the de-emphasis value of the signal generator, and to communicate on a second communication speed faster than the first communication speed after adjusting the de-emphasis value of the signal generator.

The signal processor may additionally include a signal receiver which processes equalization of signals received from the external device using a preset equalizer value, and an output which outputs the equalization-processed signals.

The information acquisition unit may receive equalizer information of the external device using the signal receiver.

The information acquisition unit may receive equalizer information of the external device by an interface method different from the interface method of the signal generator.

The foregoing and/or other features and utilities of the present invention may also be achieved by providing a signal processor including a signal receiver to process equalization of signals received from the external device using a preset equalizer value, an output unit to output the equalization-processed signals, and an information provider to provide the equalizer information corresponding to the preset equalizer value to the external device.

The signal processor may additionally include a receiver which receives data to be transmitted to the external device, and a signal generator which processes de-emphasis of the received data using a preset de-emphasis value and which outputs the resultant data to the external device. The information provider may provide the equalizer information to the external device using the signal generator.

The information provider may provide the equalizer information to the external device by an interface method different from the interface method of the signal receiver.

The foregoing and/or other features and utilities of the present invention may also be achieved by providing an electronic apparatus including a functionality unit to perform a predetermined function, a controller to control the functionality unit, and a communicating interface to transmit and receive data between the functionality unit and the controller. The communicating interface may include a first serial interface to receive data from the controller, to process de-emphasis of the received data and to output the resultant data, and a second serial interface to receive signals outputted from the first serial interface, to process equalization of the received signals and to provide the equalization-processed signals to the functionality unit. The first serial interface may receive equalizer information from the second serial interface and adjust a de-emphasis gain value of the first serial interface based on the received equalizer information.

The second serial interface may receive data from the functionality, process de-emphasis of the data, and output the resultant data, and the first serial interface may receive signals outputted from the second serial interface, process equalization of the received signals, and provide the resultant signals to the controller.

The second serial interface may receive equalizer information from the first serial interface, and adjusts a de-emphasis gain value of the second serial interface based on the received equalizer information.

The first serial interface may receive de-emphasis information from the second serial interface, and adjust an equalizer gain value of the first serial interface based on the received de-emphasis information.

The controller may control the communicating interface to communicate on a first communication speed before adjusting the de-emphasis value of the first serial interface, and to communicate on a second communication speed faster than the first communication speed after adjusting the de-emphasis value of the first serial interface.

The electronic apparatus may additionally include a storage which stores a look-up table comprising a plurality of equalizer gain values and a plurality of de-emphasis gain values corresponding to the plurality of equalizer gain values. The controller may adjust a de-emphasis gain value of the communicating interface based on the look-up table stored in the storage and the received equalizer information.

The foregoing and/or other features and utilities of the present invention may also be achieved by providing a signal processing method including receiving data to be transmitted to an external device, processing de-emphasis of the received data using a preset de-emphasis value and transmitting the resultant data, receiving equalizer information from the external device, and adjusting the preset de-emphasis value based on the received equalizer information.

The foregoing and/or other features and utilities of the present invention may also be achieved by providing a computer readable recording medium including computer-readable codes as a program to implement a signal processing method in a signal processor, wherein the signal processing method may include receiving data to be transmitted to an external device, processing de-emphasis of the received data using a preset de-emphasis value and transmitting the resultant data, receiving equalizer information from the external device, and adjusting the preset de-emphasis value based on the received equalizer information.

The foregoing and/or other features and utilities of the present invention may also be achieved by providing a signal processing system, including a first signal processor and a second signal processor. The first signal processor may include a receiver to receive data to be transmitted to an external device, a signal generator to process de-emphasis of the received data using a preset de-emphasis value and to output the resultant data to the external device, an information acquisition unit to receive equalizer information from the external device, and a controller to control the de-emphasis value of the signal generator based on the received equalizer information. The second signal processor may include a signal receiver to receive the output data of the signal generator of the first signal processor and to process equalization of the signals using a preset equalizer value, an output unit to output the equalization-processed signals, and an information provider to provide the equalizer information corresponding to the preset equalizer value to the information acquisition unit of the first signal processor.

The foregoing and/or other features and utilities of the present invention may also be achieved by providing a signal processor, including a receiver to receive data to be transmitted to an external device, and a signal generator to process a first de-emphasis of the received data using a preset de-emphasis value and to process a second de-emphasis of the received data using a variable de-emphasis value received from an external device in response to a characteristic of the first de-emphasis processed data.

The characteristic of the de-emphasis processed data may include at least one of a transmission speed and width timing of the data.

The variable de-emphasis value may correspond to an operation state of the external device.

The external device may be a new external device installed to communicate with the signal processor. The signal generator may perform a first communication with the external device according to the first de-emphasis of the data, and may perform a second communication with the external device according to the variable de-emphasis of the data.

The external device may be a functional unit to provide a new function to the electronic apparatus, and the signal generator may communicate with the external device to perform the new function of the electronic apparatus.

The above and/or other features and utilities of the present invention will be more apparent by describing certain exemplary embodiments of the present invention with reference to the accompanying drawings, in which:
FIG. 1 is a block diagram illustrating an electronic apparatus according to an embodiment of the present invention;
FIG. 2 is a detailed block diagram illustrating the electronic apparatus of FIG. 1 according to an embodiment of the present invention;
FIG. 3 is a block diagram illustrating the electronic apparatus of FIG. 1 according to an embodiment of the present invention;
FIG. 4 is a block diagram illustrating a communicating interface according to an embodiment of the present invention;
FIG. 5 is a block diagram illustrating a first signal processor of the communicating interface of FIG. 4 according to an embodiment of the present invention;
FIG. 6 illustrates the technological principle of the de-emphasis;
FIG. 7 is a diagram illustrating the implementation of the de-emphasis;
FIG. 8 is a block diagram illustrating a second signal processor of the communicating interface of FIG. 4 according to an embodiment of the present invention;
FIG. 9 illustrates the technological principle of an equalizer;
FIG. 10 illustrates the constitution of a DFE equalizer;
FIG. 11 illustrates the signal processing results by the equalizer;
FIG. 12 illustrates an operation of delivering equalizer information according to an embodiment of the present invention;
FIG. 13 illustrates an operation of delivering equalizer information according to an embodiment of the present invention;
FIG. 14 illustrates a look-up table according to an embodiment of the present invention;
FIG. 15 illustrates a look-up table according to another embodiment of the present invention;
FIG. 16 is a flowchart illustrating a method of processing signals in an electronic apparatus according to an embodiment of the present invention;
FIG. 17 is a flowchart illustrating a method of processing signals in an electronic apparatus according to an embodiment of the present invention;
FIG. 18 illustrates distortion in a waveform due to ISI;
FIG. 19 illustrates the waveform when processing de-emphasis and/or equalizer; and
FIG. 20 illustrates simulation results with the applied equalizer and with the unapplied equalizer in the same system applying with the same de-emphasis.

Reference will now be made in detail to the embodiments of the present invention, examples of which are illustrated in the accompanying drawings, wherein like reference numerals refer to the like elements throughout. The embodiments are described below in order to explain the present invention while referring to the figures.

The matters defined in the description, such as detailed construction and elements, are provided to assist in a comprehensive understanding of the present invention. Accordingly, it is apparent that the exemplary embodiments of the present invention can be carried out without those specifically defined matters. Also, well-known functions or constructions are not described in detail since they would obscure the invention with unnecessary detail.

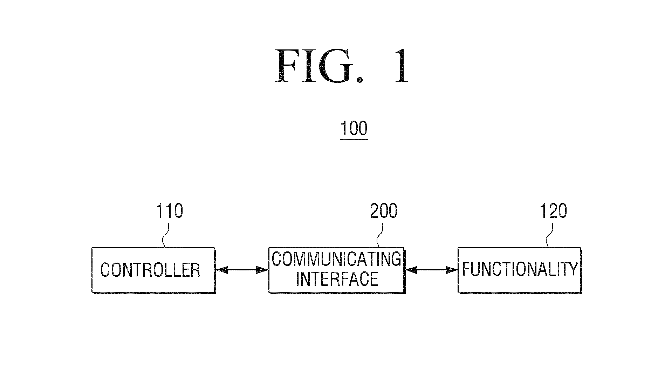

FIG. 1 is a block diagram illustrating an electronic apparatus 100 according to an embodiment of the present invention.

By referring to FIG. 1, the electronic apparatus 100 may include a controller 110, a functionality (or functionality unit or functional unit) 120, and a communicating interface 200. The electronic apparatus 100 may communicate with the internal or external devices using a serial interface, such as a personal computer (PC), a laptop computer, a tablet computer apparatus, a PMP, a smart phone, a printer, and a scanner.

The controller 110 may control components within the electronic apparatus 100. The controller 110 may determine whether controlling a gain value of de-emphasis in the communicating interface 200 is necessary or not. The controller 110 may determine the controlling the gain value of the de-emphasis to be requested in a case changing an operation of the electronic apparatus 100, for example, when the electronic apparatus 100 is booted up, or when the communicating interface 200 is initialized.

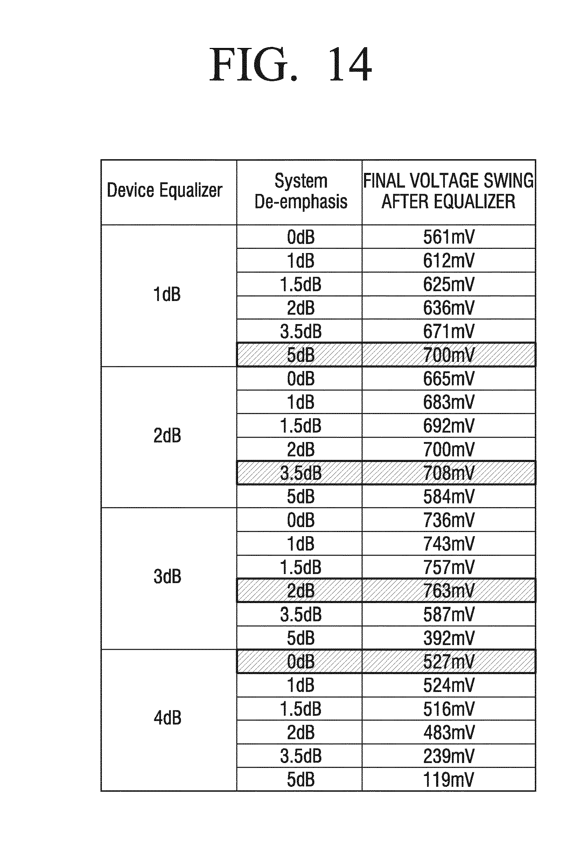

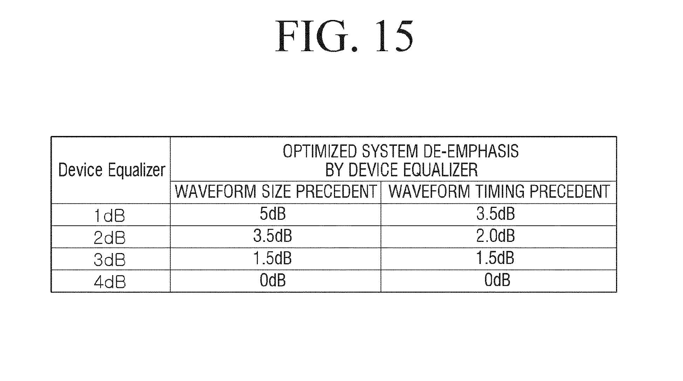

The controller 110 may control the communicating interface 200 to adjust the gain value of the de-emphasis in the communicating interface 200. The controller 110 may control the communicating interface 200 to adjust the gain value of the de-emphasis in the communicating interface 200 if the controlling the gain value is determined to be needed as described above. The controller 110 may utilize a look-up table stored in a storage, which will be described below, and control the de-emphasis gain value. Further explanation of controlling the de-emphasis gain value using the look-up table will be described below by referring to FIGS. 14 and 15.

The controller 110 may determine an operation mode of the electronic apparatus 100. Specifically, the controller 110 may determine the operation mode of the electronic apparatus 100 by considering whether there is a user manipulation, a time cost in manipulating by the user, and whether an electric power connects or not. The operation mode may include a power save mode, a battery mode utilizing the installed battery without providing the external electric power source for the operating, and a normal mode utilizing the electric power source provided externally for operation.

The functionality 120 may perform a predetermined function thereof. The functionality 120 may communicate with the controller 110 using the communicating interface 200, and perform a predetermined function according to controlling of the controller 110. The functionality 120 may be the CD-ROM, the DVD reader, or the blue-ray player reading the data of the optical disk, and also, the nonvolatile memory such as the Hard Disk Drive (HDD) or the Solid-State Drive (SDD), and also, a printing engine to perform printing on a print medium using data and/or a scanner to perform scanning if the electronic device 100 is a combination apparatus.

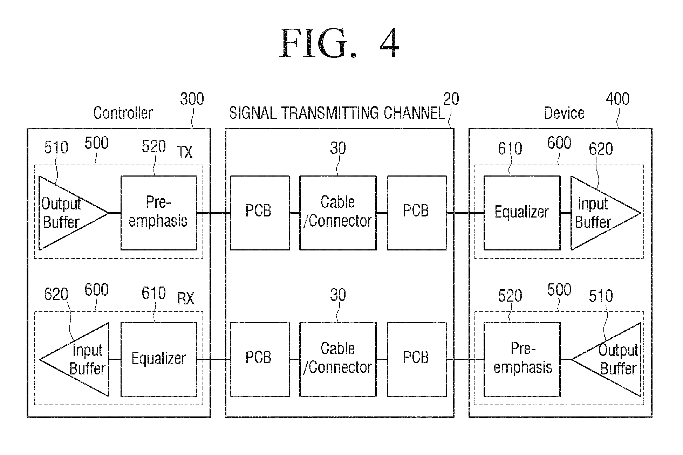

The communicating interface 200 may transmit and receive the data between the functionality 120 and the controller 110. The communicating interface 200 may transmit and receive the data by a serial interface method. The operation of transmitting and receiving the data by the serial interface method will be described below by referring to FIG. 4. The serial interface may be the Serial ATA (SATA). Meanwhile, in one embodiment, the communicating interface 200 may operate in the serial interface method; however, the communicating interface 200 may support other interface methods as well as the serial interface method when operating.

The electronic apparatus 100 according to an embodiment may control the gain value of the de-emphasis in the communicating interface adaptively to the system environment. Thus, the user can utilize a high speed communication with a newly installed device to the electronic apparatus more safely or reliably.

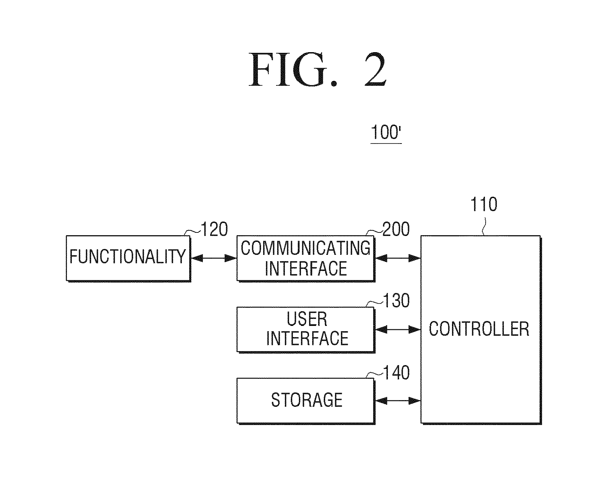

FIG. 2 is a block diagram illustrating an electronic apparatus 100' according to an embodiment of the present invention.

By referring to FIG. 2, the electronic apparatus 100' may include a controller 110, a functionality 120, a user interface 130, a storage 140 and a communicating interface 200.

The controller 110, the functionality 120, and the communicating interface 200 of the electronic apparatus 100' of FIG. 2 may be similar to the electronic apparatus 100 of FIG. 1 and are described in FIG. 1, which will not be further explained for the sake of brevity.

The user interface 130 may include various function keys with which a user can set or select the functions provided by the electronic apparatus 100', and may display various information provided by the electronic apparatus 100'. The user interface 130 may be implemented in the form such as touch screen or panel to simultaneous provide input and output units, or a device combining a mouse and a monitor.

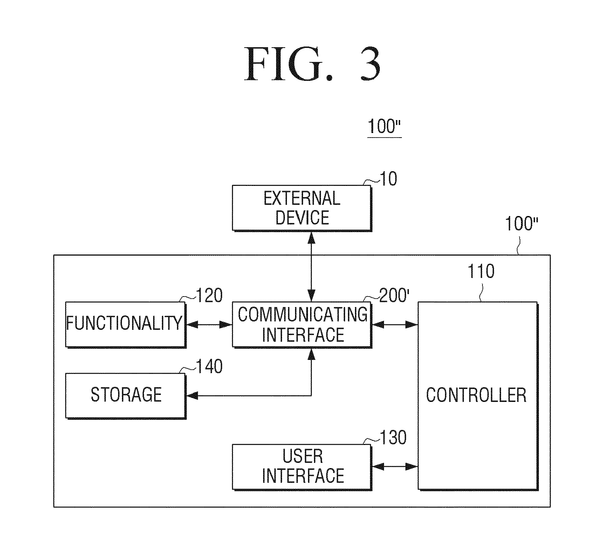

The storage 140 may store programs to drive the electronic apparatus 100'. The storage 140 may store programs of the class including the various command language when operating. The program may include a Master Boot Record (MBR, or a GUID Partition Table (GTP)) and an Operation System (OS). Meanwhile, although the embodiment illustrates that the storage 140 and the controller 100 directly transmits and receives the data, the storage 140 may communicate with the controller 110 through the communicating interface 200 as illustrated in FIG. 3. The storage 140 and the controller 110 may connect to each other by the serial interface method.

The storage 140 may store a look-up table. The look-up table may be a table to record or provide gain values of a plurality of equalizers and gain values of a plurality of de-emphasis corresponding to a plurality of equalizer gain values. The look-up table may be optimized according to various experiments by manufacturers, and the look-up table may be renewed by updating firmware or other methods thereof. The look-up table may be stored in the Basic Input Output System (BIOS) of an electronic apparatus. The BIOS may store the basic information to initialize components within an electronic apparatus. Meanwhile, the look-up table may classify the gain values of the de-emphasis by a first condition and the gain values of the de-emphasis by a second condition and record both of them. Further detailed constitution of the look-up table will be described below by referring to FIGS. 14 and 15.

When describing FIGS. 1 and 2, the communicating interface 200 may be provided between the functionality 120 and the controller 110 within the electronic apparatus 100 and transmit and receive the signals between the functionality 120 and the controller 110. However, the communicating interface 200 may be utilized to transmit and receive the data or the controlling signals by the serial interface method as well as the data between the above two components. Further, although the drawings illustrate that the communicating interface 200 is provided between the components, alternatively, the communicating interface 200 may communicate with the external device. This will be further explained below by referring to FIG. 3.

FIG. 3 is a block diagram illustrating an electronic apparatus 100" according to an embodiment of the present invention.

By referring to FIG. 3, the electronic apparatus 100" may include a controller 110, a functionality 120, a user interface 130, a storage 140 and a communicating interface 200'. Compared to FIG. 2, the storage 140 may be connected to the controller 110 through the communicating interface 200', and the communicating interface 200' may be connected to an external device 10.

The communicating interface 200' may be installed to connect the electronic apparatus 100" to the external device 10 through the Local Area Network (LAN) and the internet network, and also, the wireless communication such as the GSM, the UMTS, the LTE, and the WiBRO.

The communicating interface 200' may transmit and receive the data with the external device 10 by the serial interface method. The communicating interface 200' as illustrated in FIG. 4 may include one or more components, for example, a first serial interface 300 provided within the electronic apparatus 100" and a second serial interface 400 provided in the external device 10.

Further, as described by referring to FIG. 2, the communicating interface 200' may transmit and receive the data between the functionality 120, the storage 140 and the controller 110 within the electronic apparatus 100.

FIG. 4 is a block diagram illustrating a communicating interface200 (or 200') according to an embodiment of the present invention.

By referring to FIG. 4, the communicating interface 200 may include a first serial interface 300, a signal transmitting channel 20, and a second serial interface 400. To explain more easily, a component to transmit and/or receive the data through the first serial interface 300 may be referred to as a first device, and a component to transmit and/or receive the data through the second serial interface 400 may be referred to as a second device. For instance, the first and second devices may be the controller 110 and the functionality 120 of FIG. 1, the controller 110 and the storage 140 of FIG. 3, or the electronic apparatus 100 (100' or 110") and the external device in FIG. 3.

The first serial interface 300 may transmit the data received from the first device to the second serial interface 400 by the serial interface method, and transmit the signals received from the second serial interface 400 by the serial interface method to the first device. The first serial interface 300 may include a first signal processor 500 to perform the transmitting operation and a second signal processor 600 to perform the receiving operation.

The second serial interface 400 may transmit the data received from the second device to the first serial interface 300 by the serial interface method and transmit the signals received from the first serial interface 300 by the serial interface method to the second device. The second serial interface 400 may include the first signal processor 500 to perform the transmitting operation and the second signal processor 600 to perform the receiving operation.

The first serial interface 300 and the second serial interface 400 may have the same constitution and operation except the placement of the component near to other components. Thus, the first signal processor 500 of the first serial interface 300 and the second signal processor 600 of the second serial interface 400 will be described below.

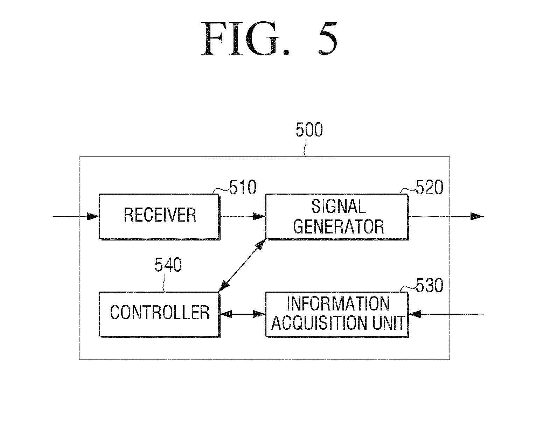

FIG. 5 illustrates a detailed block diagram illustrating the first signal processor 500 of FIG. 4. To explain more easily, the first signal processor 500 of the first serial interface 300 will be described below.

By referring to FIG. 5, the first signal processor 500 may include a receiver 510, a signal generator 520, an information acquisition unit 530 and a controller 540.

The receiver 510 may receive the data which will be transmitted to the external device. The receiver 510 may receive the data to be transmitted from the first device to the external device, for example, the second device.

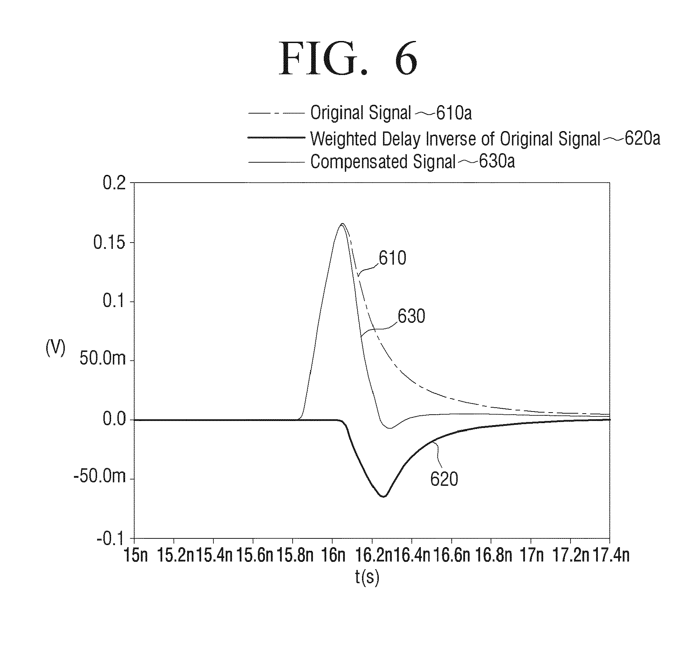

The signal generator 520 may include a de-emphasis unit to de-emphasise a signal. The signal generator 520 may process de-emphasis of the received data. The signal generator 520 may process de-emphasis of the data received from the receiver 510 using a preset de-emphasis value, for example, using a preset de-emphasis gain value. Meanwhile, the de-emphasis value, i.e., the de-emphasis gain value, may be adjusted under controlling of the controller which will be described below. The "de-emphasis technology" as used herein refers to a technology implemented to compensate for influence occurring due to previous bits in a process of constructing current bits, and will be described in greater detail below by referring to FIG. 6.

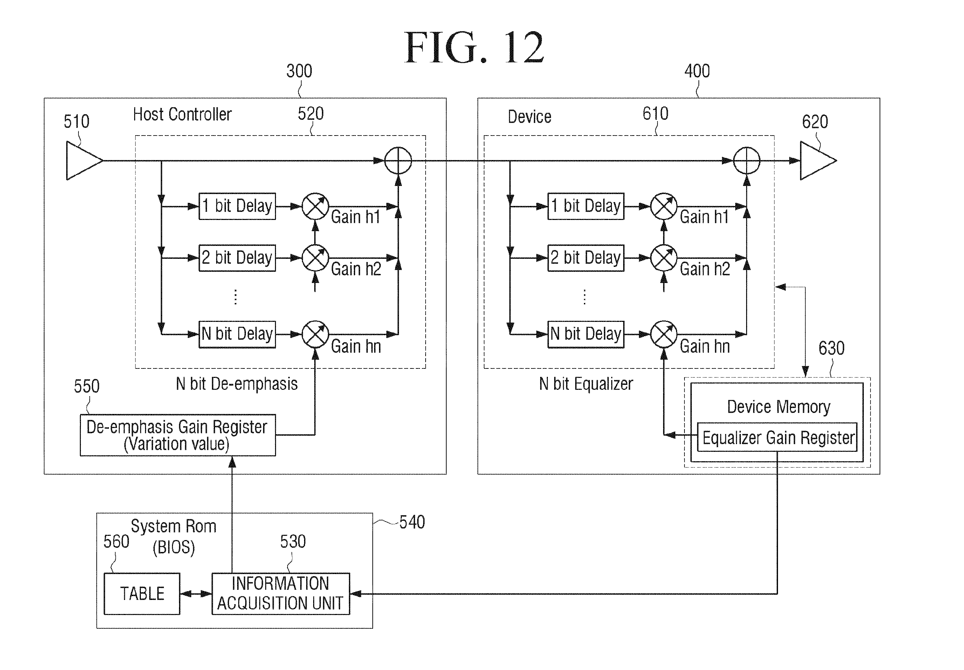

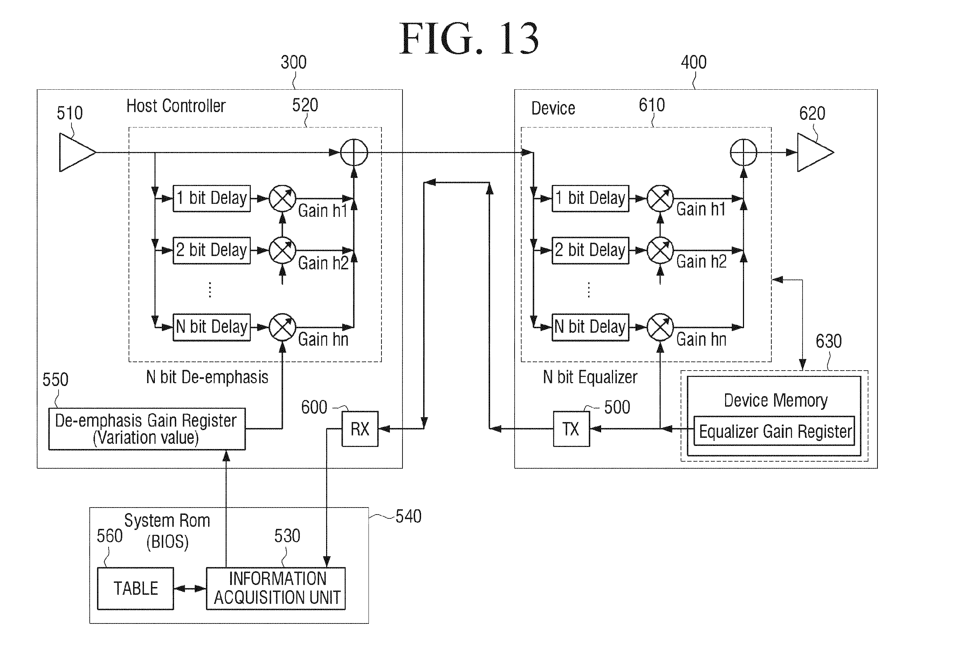

The signal generator 520 may output signals after de-emphasis. The signal generator 520 may transmit the resultant signals of de-emphasis to the second serial interface 400 through a signal transmitting channel 20 of FIG. 4. The signal generator 520 may communicate on a first communication speed before adjusting the de-emphasis value and then on a second communication speed after adjusting the de-emphasis value. The information acquisition unit 530 may receive equalizer information from the external device, for example, from the second serial interface 400. The information acquisition unit 530 may utilize the serial interface method or other interface methods, and receive the equalizer information from the external device, for example, from the second serial interface 400. The receiving of the equalizer information by other interface methods will be described below by referring to FIG. 12. Receiving the equalizer information by the serial interface method will be described below by referring to FIG. 13.

The controller 540 may adjust the de-emphasis value of the signal generator 520. The controller 540 may utilize the equalizer information received from the information acquisition unit 530 and the prestored look-up table, select the de-emphasis value to be applied in the signal generator 520, and adjust the de-emphasis value of the signal generator 520 by the de-emphasis value.

Meanwhile, as illustrated in FIG. 15, the look-up table may have the de-emphasis values per condition, such as the de-emphasis values of the first condition and the second condition. The controller 540 may determine one of the de-emphasis value in the first condition and the de-emphasis value in the second condition to be applied. For instance, if the electric power is needed to be saved in communicating, the controller 540 may determine the de-emphasis value in the first condition considering a waveform size as precedent to be utilized, or as a "priority condition". If signal timing is more important than the electric power saving, the controller 540 may determine the de-emphasis value in the second condition considering a timing width as precedent to be utilized.

The controller 540 may determine the communication speed of the signal processor 500. When the high speed communication operates immediately without knowing the equalizer information of the second serial interface, the signal features may be deteriorated as illustrated in FIG. 20B. The controller 540 may control the signal generator 520 to operate on a low speed of the first communication speed at a time of initializing the communication, for example, at a time of booting the electronic apparatus up. If the de-emphasis value of the signal generator 520 is adjusted, the controller 540 may control the signal generator 520 to operate at a high speed of the second communication speed. As such, the first signal processor 500 may adaptively adjust the de-emphasis value, the user can utilize the high speed communication with a newly installed device to the electronic apparatus 100 (100') more safely and reliably in a case of operating serial communication with the new device.

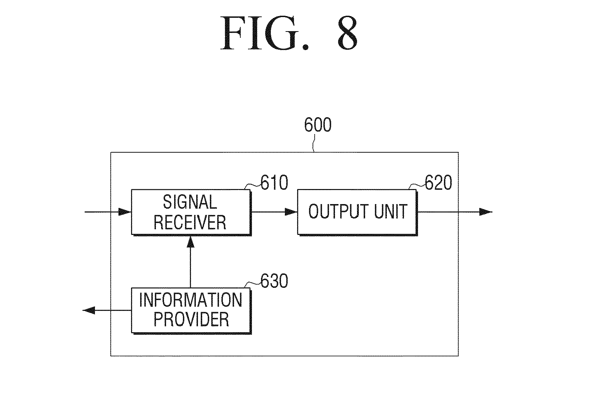

Meanwhile, the above describes that the first signal processor 500 may perform the transmitting the signals. However, the first signal processor 500 may be provided to include the components as illustrated in FIG. 8. The first signal processor 500 may be the same constitution as the serial interface as illustrated in FIG. 4.

Further, even though the above describes that the controller 540 may be included in the first signal processor 500, the controller 540 may be installed outside of the first signal processor 500. For instance, the controller 110 in FIGS. 1 to 3 may perform the function of the controller 540, and in this case, the controller 110 may be the BIOS.

FIG. 6 illustrates a de-emphasis technology with an original signal 610a, a weighted delay inverse 620a of the original signal 610a, and a compensated signal 630a.

If the transmitting timing per one bit of the data is greater than the bandwidth of the transmitting channel, the signal may have waveform distortion affected by the previous bits, which is known as inter-symbol interference (ISI).

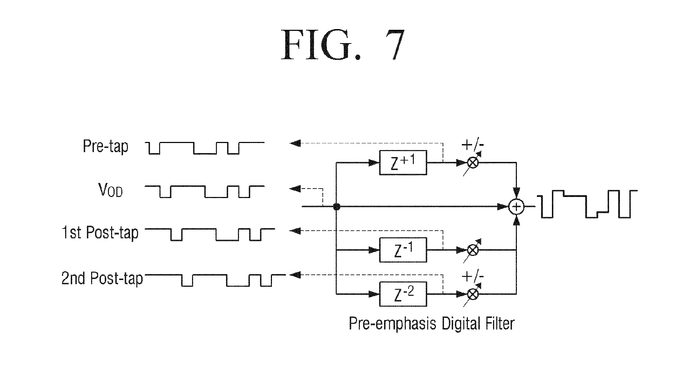

To improve the loss in the waveform by ISI, the de-emphasis technology may operate in compensating the effects by the previous bits when generating the current bit as illustrated in FIG. 6. The circuits of the de-emphasis technology are described in FIG. 7.

Meanwhile, by referring to FIG. 7, when applying the de-emphasis technology, a compensation degree of the previous bit effects may be adjusted by controlling a gain value. In one embodiment, the compensation degree in processing de-emphasis of a signal V_{OD} may be adjusted by the compensation degree of an equalizer, which will be described below. The notation "z⁻¹" refers to the delay of the signal V_{OD} by one time period, as understood in the art, and as described in more detail below.

FIG. 8 illustrates the second signal processor 600. To explain more easily, the second signal processor 600 within the second serial interface 400 will be described below.

By referring to FIG. 8, the second signal processor 600 may include a signal receiver 610, an output unit 620 and an information provider 630.

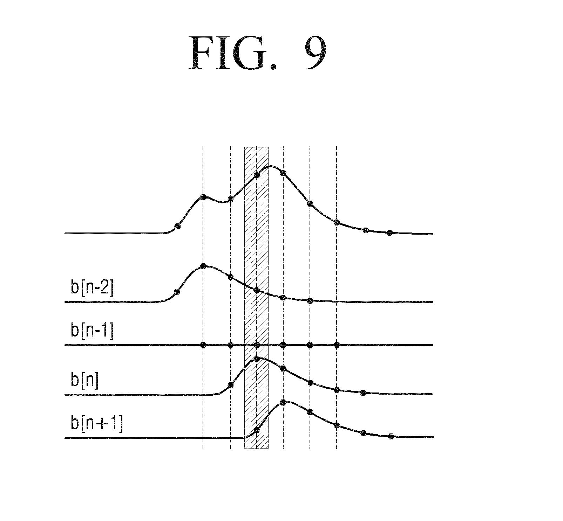

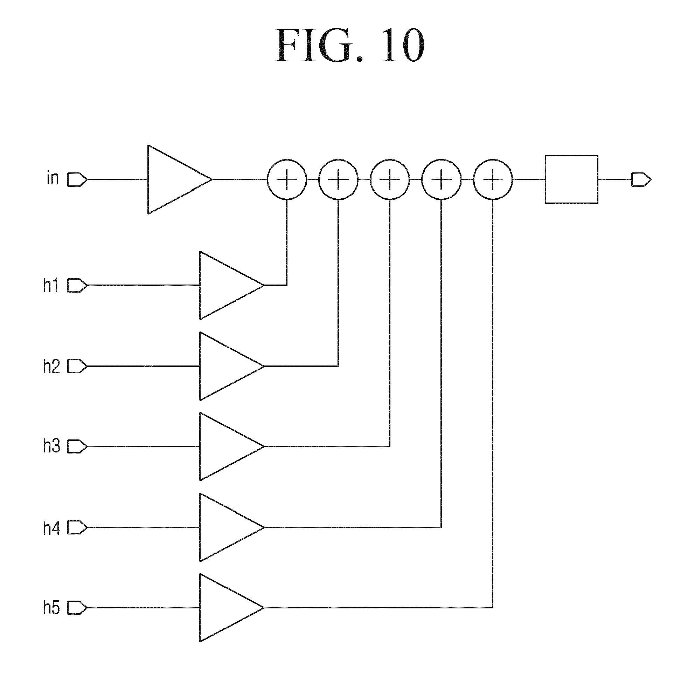

The signal receiver 610 may include an equalizer. The signal receiver 610 may perform an equalization process to the signals received from the external device using a preset equalizer value. Detail processing of the equalizer will be described below by referring to FIGS. 9 and 10.

The output unit 620 may output the equalization-processed signals. The output unit 620 may provide the equalization-processed signals in the signal receiver 610 to the second device.

The information provider 630 may set the equalizer value of the signal receiver 610. The information provider 630 may previously store an equalizer setting value. If the second signal processor 660 boots up and initializes, the prestored equalizer setting value may be set as the equalizer value of the signal receiver 610. The equalizer setting value may be stored in a ROM storing the information regarding the devices.

The information provider 630 may provide the equalizer information corresponding to the preset equalizer value to the external device, for example, the first serial interface 300. The information provider 630 may provide the information regarding the equalizer value of the signal receiver 610, more specifically, the equalizer gain value to the first serial interface 300.

The second signal processor 600 according to the above embodiment may provide the equalizer information to adjust the de-emphasis gain value of the first signal processor 500, and thus, the high speed communication can operate more safely and reliably.

Meanwhile, the above describes that the second signal processor 600 may receive the signals. However, the second signal processor 600 may be implemented to include the components as illustrated in FIG. 5. The second signal processor 600 may be the same constitution as the serial interface as illustrated in FIG. 4.

FIG. 9 is provided to explain the equalizer technology.

The equalizer technology may remove an inter symbol interference (ISI) on a receiving end to improve a waveform thereof. One of the representative equalizer technologies is the Decision Feedback Equalization (DFE). When the signal transmitting channel is the Linear Timer Invariant (LTI) system, the ISI may be found to be analyzed as several overlapping waveforms b[n-2], b[n-1], b[n], b[n+1] of the time-shifted pulse as illustrated in FIG. 9. The DFE method may utilize the ISI analyzing method as illustrated in FIG. 9, remove the waveforms of the previous bits from the current bit, and restore the waveform of the current bit only. The circuits of the equalizer technology are illustrated in FIG. 10.

Meanwhile, by referring to FIG. 10, when applying the equalizer technology, the degree in compensating a waveform "in" may be adjusted by controlling one or more gain values h1, h2, h3, h4, h5, for example. When implementing, according to the gain value of the de-emphasis, the compensation degree of processing the equalizer may be adjusted. The de-emphasis gain value may be adjusted using the equalizer information. However, when implementing, the receiving end may receive the information of the de-emphasis gain value from the transmitting end, and the value may be adjusted to the equalizer gain value responding to the received de-emphasis gain value.

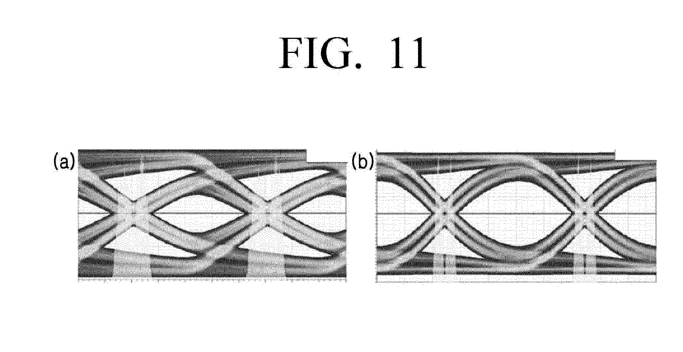

FIG. 11 illustrates the signal processing results by the equalizer. FIG. 11 illustrates a waveform (a) with the unapplied equalizer technology and a waveform (b) with the applied equalizer technology.

By referring to the waveforms (a) and (b) of FIG. 11, the ISI may be removed efficiently by applying the equalizer technology.

Meanwhile, as described above, the transmitting end may utilize the de-emphasis technology and the receiving end may utilize the equalizer technology when communication on the high speed of GHz bandwidth. In the source transmitting channel, or the system fixing the receiver, the optimized de-emphasis gain value and the equalizer gain value may be possible to be set. However, if the user sets the device optionally, because the equalizer setting value of the system may not be found, a preset de-emphasis value gain value may be utilized independently regardless of consideration of the equalizer features.

However, as described above in explaining the conventional technology, if the de-emphasis gain value is set without considering the equalizer features, serious faults may occur. In one embodiment, the de-emphasis gain value may be adjusted by considering the equalizer information, in other words, the equalizer gain value. By referring to FIGS. 12 and 13, the method of receiving the equalizer information on the receiving end will be described below. By referring to FIGS. 14 and 15, the method of adjusting the de-emphasis gain value using the received equalizer information will be described below.

FIG. 12 illustrates an operation of delivering equalizer information according to an embodiment of the present invention.

By referring to FIG. 12, the communicating interface 200 may include the first serial interface 300 and the second serial interface 400.

The first serial interface 300 may process de-emphasis of the data received from the first device and output the resultant data to the second serial interface 400. Meanwhile, the above drawing illustrates that the first serial interface 300 may include the first signal processor 500; however, when implementing, the first serial interface 300 may further include the second signal processor 600.

The second serial interface 400 may process equalization of the signals received from the first serial interface 300 and provide result to the second device. Meanwhile, in the above embodiment, the second serial interface 400 may include the second signal processor 600 only; however, when implementing, the second serial interface 400 may further include the first signal processor 500.

The second serial interface 400 may provide the equalizer information applied in the signal receiver 610, more specifically, the equalizer gain value using another communication bus to the first serial interface 300 if the communicating interface 200 initializes and the first serial interface 300 requests. The communication bus may be the I2C; however, the present invention is not limited to this.

The controller 540 receiving the equalizer information may select the de-emphasis gain value to be applied in the signal generator 520 using the received equalizer information and the prestored look-up table, and control the de-emphasis gain value of the signal generator 520 by the selected gain value.

The illustration describes that the controller 540 may be the external device of the first serial interface 300. However, when implementing, the controller 540 may be installed within the first serial interface 300.

The first serial interface 300 may include a receiver 510, a signal generator 520, and a de-emphasis gain register 550 as illustrated in FIGS. 5 and 12. The second serial interface 400 may include a signal receiver 610, an output unit 620, and an information provider 630 as illustrated in FIGS. 8 and 12. The controller 540 may include an information acquisition unit 530 and a table 560 in a system ROM, for example, BIOS.

FIG. 13 illustrates an operation of delivering equalizer information according to an embodiment of the present invention.

By referring to FIG. 13, the communicating interface 200 may include a first serial interface 300 and the second serial interface 400.

The first serial interface 300 may process de-emphasis of the data received from the first device and output the result to the second serial interface 400. The first serial interface 300 may process equalization of the signals received from the second serial interface 400 and provide the result to the first device.

The second serial interface 400 may process equalization of the signals received from the first serial interface 300 and provide the result to the second device. The second serial interface 400 may process de-emphasis of the data received from the second device and output the result to the first serial interface 400.

The second serial interface 400 may provide the equalizer information applied in the signal receiver 610, for example, provide the equalizer gain value using the first signal processor 500 within the second serial interface 400 to the first serial interface 300, if the communicating interface 200 initializes and the first serial interface 300 requests the equalizer information.

The controller 540 receiving the equalizer information may utilize the received equalizer information and the prestored look-up table, select the de-emphasis gain value to be applied in the signal generator 520, and adjust the de-emphasis gain value of the signal generator 520 to be the selected gain value.

The illustration describes that the controller 540 may be the external device of the first serial interface 430. However, when implementing, the controller 540 may be installed within the first serial interface 300.

The above describes the adjusting the de-emphasis gain value of the transmitting end using the equalizer information of the receiving end. However, when implementing, the equalizer gain value of the receiving end may be adjusted using the de-emphasis gain value of the transmitting end.

FIG. 14 illustrates an example of a look-up table usable in a communication interface of an electronic apparatus according to an embodiment of the present invention.

By referring to FIG. 14, the look-up table according to an embodiment may include a plurality of equalizer gain values and a plurality of de-emphasis gain values corresponding to each of a plurality of equalizer gain values. For instance, if the equalizer gain value is 3 dB, the transmitting end may select the gain value of 1.3 dB having the optimized waveform in the 3 dB.

The look-up table may be stored in the BIOS storing the basic information to initialize the electronic apparatus. A conventional BIOS has a fixed value of the de-emphasis. However, in one embodiment, because of having the look-up table as illustrated in FIG. 14 or FIG. 15, the de-emphasis value may be adjusted to adapt in the connected device.

Although the drawing illustrates one equalizer gain value with a plurality of de-emphasis gain values, one equalizer gain value may have one responding de-emphasis gain value when implementing.

Although the above describes that the look-up table may be utilized to determine the de-emphasis gain value with one condition, in other words, the equalizer gain value, the de-emphasis gain value may be determined in each of a plurality of conditions. This will be further explained below by referring to FIG. 15.

FIG. 15 illustrates a look-up table usable in a communication interface of an electronic apparatus according to an embodiment of the present invention.

By referring to FIG. 15, the look-up table according to another embodiment may include a plurality of equalizer gain values, the de-emphasis gain value on the first condition responding to each of a plurality of equalizer gain values, and the de-emphasis gain value on the second condition responding to each of a plurality of equalizer gain values. The first condition may consider the waveform size of the signal as the precedent and the second condition may consider the timing width of the signal as the precedent.

According to the system establishment, the establishment margin in the size of the waveform may be insufficient, or the establishment margin in the width of the waveform timing may be insufficient. Thus, according to another embodiment, the different two conditions may be provided as illustrated in FIG. 15, and the establishment builder may selectively provide the priority according to the system margin.

For instance, in the battery mode requesting the electric power saving, the de-emphasis gain value on the first condition may be utilized. Specifically, if the equalizer gain value of the receiving end is 2 dB and if the operating mode of the electronic apparatus is the battery mode, the receiving end may select the gain value of 3.5 dB and the de-emphasis gain value of the receiving end may be adjusted with the selected gain value, 3.5 dB.

The selecting may be based on the operation of the electronic apparatus as described above, and may be determined by the setting of the BIOS. Specifically, with the menu of the Complementary Metal Oxide Silicon (CMOS) within the BIOS, a user may previously select one of the first condition and the second condition to set the de-emphasis value, and the controller may select the de-emphasis value by the user selection.

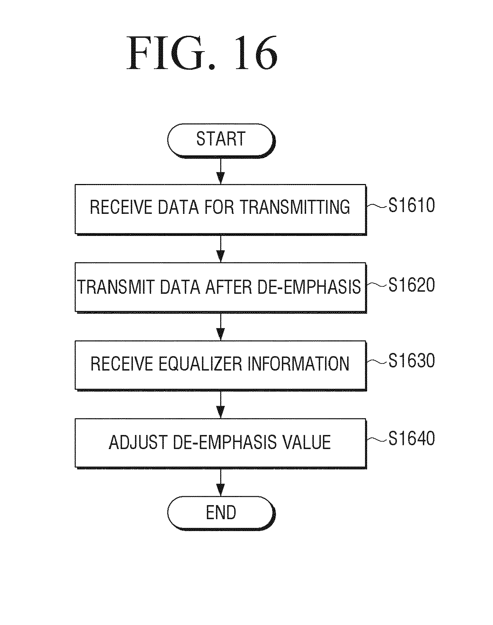

FIG. 16 is a flowchart illustrating a signal processing method of an electronic apparatus according to an embodiment of the present invention.

By referring to FIG. 16, the data may be received to be transmitted to the external device at operation S1610. The data may be received from the first device to transmit result to the external device, specifically, the second device.

At operation S1620, using a preset de-emphasis value, received data may be resultant and transmitted. The processing de-emphasis of may be implemented using a preset de-emphasis value, specifically, the de-emphasis gain value regarding received data. The resultant data may be transmitted to the external device.

The equalizer information may be received from the external device at operation S1630. Using the serial interface method or the other interface methods, the equalizer information, specifically, the equalizer gain value may be received from the external device.

At operation S1640, a preset de-emphasis value may be adjusted based on the received equalizer information. Specifically, the de-emphasis value may be selected using the received equalizer information and the previously stored look-up table, and the de-emphasis value of the signal generator 520 may be adjusted with the selected de-emphasis value.

The signal processing method according to an embodiment may adjust the de-emphasis gain value adaptively to the system by receiving the equalizer information from the receiving end. Thus, if new device is installed, the high speed communication with the newly installed device may be utilized more safely. The signal processing method of FIG. 16 may be performed by the electronic apparatus having the components of FIGS. 1 to 3, the communicating interface having the components of FIG. 4, and the signal processor having the components of FIG. 5, or electronic apparatuses having other components, another communicating interface, and another signal processor.

Further, the signal processing method according to an embodiment as described above may be implemented by the programs including the algorithms available on the computer. The above programs may be stored and provided in the non-transitory computer readable medium.

The non-transitory computer readable medium may be not the medium storing the data temporarily such as the register, the cache, or the memory, but the medium storing the data semi-permanently that can be readable by the device. Specifically, the above various applications or programs may be stored and provided in the non-transitory computer readable medium such as the CD, the DVD, the hard disk, the blu-ray disk, the USB, the memory card, or the ROM.

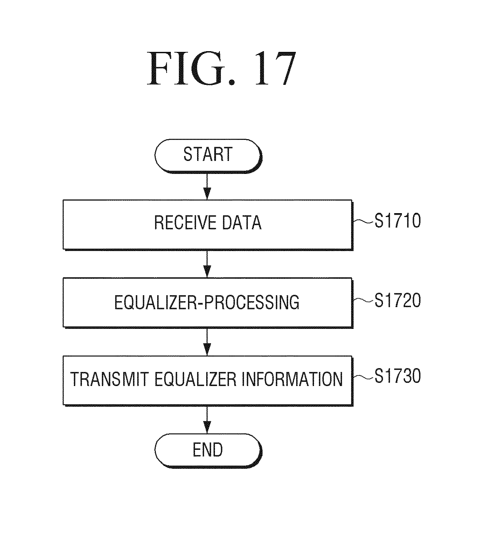

FIG. 17 illustrates a flowchart illustrating a signal processing method usable in a communication interface of an electronic apparatus according to an embodiment of the present invention.

At operation S1710, the signals transmitted by the serial interface may be received.

At operation S1720, the received signals may be equalization-processed using a preset equalizer value and the equalization-processed signals may be outputted at operation S1720.

At operation S1730, the equalizer information corresponding to the preset equalizer value may be provided to the external device. The information of the currently utilized equalizer value, specifically, the equalizer gain value, when processes equalization of may be provided to the external device using the serial interface method or the other interface methods.

The signal processing method according to another embodiment as described above may provide the equalizer information to the transmitting end. Thus, the receiving end may adjust the de-emphasis gain value adaptively to the system, and the user can utilize the high speed communication more safely and reliably. The signal processing method of FIG. 17 may be implemented by the electronic apparatus having the components of FIGS. 1 to 3, the communicating interface having the components of FIG. 4, and the signal processor having the components of FIG. 8, or electronic apparatuses having the other components, another communicating interface, and another signal processor.

Further, the signal processing method according to an embodiment as described above may be implemented by the programs including the algorithms available on the computer. The programs may be stored and provided in the non-transitory computer readable medium.

The non-transitory computer readable medium may be not the medium storing the data temporarily such as the register, the cache, or the memory, but the medium storing the data semi-permanently that can be readable by the device. Specifically, the above various applications or programs may be stored and provided in the non-transitory computer readable medium such as the CD, the DVD, the hard disk, the blu-ray disk, the USB, the memory card, or the ROM.

Although a few embodiments of the present invention have been shown and described, it will be appreciated by those skilled in the art that changes may be made in these embodiments without departing from the invention, the scope of which is defined in the appended claims.

## Claims

1. A signal processor, comprising:
a receiver to receive data to be transmitted to an external device;
a signal generator to process de-emphasis of the received data using a preset de-emphasis value, and to output the resultant data to the external device;
an information acquisition unit to receive equalizer information from the external device; and
a controller to control the de-emphasis value of the signal generator based on the received equalizer information.

2. The signal processor of claim 1, wherein the equalizer information comprises a gain value of an equalizer provided in the external device.

3. The signal processor of claim 1 or 2, further comprising:
a storage to store a look-up table having a plurality of equalizer gain values and a plurality of de-emphasis gain values corresponding to the plurality of equalizer gain values,
wherein the controller controls the de-emphasis gain value of the signal generator based on the look-up table stored in the storage and the received equalizer information.

4. The signal processor of claim 3, wherein:
the look-up table classifies and stores the de-emphasis gain values based on whether the de-emphasis gain values meet a first condition or a second condition; and
the controller controls the de-emphasis gain value of the signal generator according to the de-emphasis gain values meeting the first condition and the de-emphasis gain values meeting the second condition, depending on an operation status of the signal processor.

5. The signal processor of claim 4, wherein the first condition gives a priority to a size of a signal waveform and the second condition gives a priority to a width of signal timing.

6. The signal processor of any of claims 1 to 5, wherein the controller controls the signal generator to communicate at a first communication speed before adjusting the de-emphasis value of the signal generator, and to communicate at a second communication speed faster than the first communication speed after adjusting the de-emphasis value of the signal generator.

7. The signal processor of any of claims 1 to 6, further comprising:
a signal receiver to process equalization of signals received from the external device using a preset equalizer value; and
an output unit to output the equalization-processed signals.

8. The signal processor of claim 7, wherein the information acquisition unit receives equalizer information of the external device using the signal receiver.

9. The signal processor of any of claims 1 to 7, wherein the information acquisition unit receives equalizer information of the external device by an interface method different from the interface method of the signal generator.

10. An electronic apparatus, comprising:
a functionality unit to perform a predetermined function;
a controller to control the functionality unit; and
a communicating interface to provide data transmission between the functionality and the controller,
wherein the communicating interface includes a first serial interface to receive data from the controller, process de-emphasis of the received data and to output the resultant data, and a second serial interface to receive signals outputted from the first serial interface, process equalization of the received signals and to provide the equalization-processed signals to the functionality unit,
wherein the first serial interface receives equalizer information from the second serial interface and adjusts a de-emphasis gain value of the first serial interface based on the received equalizer information.

11. The electronic apparatus of claim 10, wherein the second serial interface receives data from the functionality, processes de-emphasis of the data, and outputs the resultant data, and the first serial interface receives signals outputted from the second serial interface, processes equalization of the received signals, and provides the resultant signals to the controller.

12. A signal processing method, comprising:
receiving data to be transmitted to an external device;
processing de-emphasis of the received data using a preset de-emphasis value and transmitting the resultant data;
receiving equalizer information from the external device; and
adjusting the preset de-emphasis value based on the received equalizer information.
